# EUROPÄISCHE PATENTSCHRIFT

(11) **EP 1 168 620 B1**
(45) Veröffentlichungstag und Bekanntmachung des Hinweises auf die Patenterteilung: **27.08.2003**
(21) Anmeldenummer: 01114267.6
(22) Anmeldetag: 12.06.2001
(51) Int. Cl.: H03K 17/12, H03K 17/567

(54) **Multichip-Halbleiteranordnung**
Multichip semiconductor device
Dispositif semiconducteur multipuce

(30) Priorität: 28.06.2000 DE 10031462
(43) Veröffentlichungstag der Anmeldung: 02.01.2002
(73) Patentinhaber: eupec Europäische Gesellschaft für Leistungshalbleiter mbH & Co. KG, 59581 Warstein (DE)
(72) Erfinder: Ruff, Martin, Dr., 91487 Vestenbergsgreuth (DE); Weis, Benno, 91334 Hemhofen (DE)
(74) Vertreter: Müller - Hoffmann & Partner

(56) Entgegenhaltungen:
- EP-A- 0 352 516
- EP-A- 0 959 563
- DE-A- 3 230 079
- US-A- 4 207 478
- US-A- 5 227 655
- US-A- 5 949 273
- "MIS EN PARALLELE DE MOSFET" ELECTRONIQUE, CEP COMMUNICATION, PARIS, FR, Nr. 36, 1. März 1994 (1994-03-01), Seiten 86-87, XP000440248 ISSN: 1157-1152

## Beschreibung

Die vorliegende Erfindung betrifft eine Multichip-Anordnung aus einer Vielzahl zueinander in einem Modul parallel geschalteter Halbleiterchips, deren Steueranschlüsse gemeinsam jeweils über einen Widerstand und eine Diode an eine externe Treiberschaltung angeschlossen sind, wobei das Modul nur einen Gate- und Klemmanschluß hat und innerhalb jedes Halbleiterchips die jeweiligen Widerstände und Dioden parallel zueinander geschaltet sind und die jeweiligen Parallelschaltungen der Widerstände und Dioden der einzelnen Halbleiterchips gemeinsam an den Gate- und Klemmanschluß angeschlossen sind.

In Fig. 4 ist eine Multichip-Anordnung aus n zueinander in einem Modul M bzw. in einer Scheibenzelle parallel zueinander geschalteter Halbleiterchips Ch1, Ch2, ..., Chn gezeigt. In jedem Halbleiterchip Ch1, Ch2, ..., Chn ist als Beispiel eines Leistungshalbleiterbauelements ein IGBT (BipolarTransistor mit isoliertem Gate) realisiert. Anstelle eines solchen IGBT kann auch ein anderes Leistungshalbleiterbauelement verwirklicht sein, wie beispielsweise ein MOS-Feldeffekt-Leistungstransistor, ein Thyristor oder dergleichen.

Gateanschlüsse LG1, LG2, ..., LGn der Chips Ch1, Ch2, ..., Chn sind an einem Punkt P im Modul M zusammengefaßt, wobei dieser Punkt M mit einem externen Gateanschluß G des Moduls M verbunden ist. Dieser externe Gateanschluß G steht somit einem Anwender des Moduls M von außen zur Verfügung.

Um nun Schwingungen zwischen den einzelnen Chips Ch1, Ch2, ..., Chn zu vermeiden, befindet sich zwischen jedem Gateanschluß LG1, LG2, ..., LGn der einzelnen Chips Ch1, Ch2, ..., Chn und der eigentlichen Gateelektrode des IGBTs ein Widerstand RG1, RG2, ..., RGn. Damit liegt zwischen zwei Gates der Chips immer eine Reihenschaltung von zwei Widerständen. Werden beispielsweise die Chips Ch1 und Ch2 betrachtet, so besteht diese Reihenschaltung aus den Widerständen RG1 und RG2, die über den Gateanschluß LG1, den Punkt P und den Gateanschluß LG2 miteinander verbunden sind.

Von einem Anwender wird der Modul-Gateanschluß G mit einer externen Treiberstufe T verbunden, die unter anderem eine Reihenschaltung aus einem ersten Schalter S1, einem ersten Widerstand R1, einem zweiten Widerstand R2 und einem zweiten Schalter S2 zwischen einer positiven Spannungsquelle PS und einer negativen Spannungsquelle NS aufweist. Der Gateanschluß G liegt dabei an dem Verbindungspunkt zwischen den beiden Widerständen R1 und R2 und kann somit - abhängig von der Stellung der Schalter S1 und S2 - mit dem Potential der positiven Spannungsquelle PS, vermindert um den Spannungsabfall am Widerstand R1, mit dem Potential der negativen Spannungsquelle NS, vermindert um den Spannungsabfall am Widerstand R2, und mit einem entsprechend dem Widerstandsverhältnis der Widerstände R1 und R2 zwischen dem Potential der positiven Spannungsquelle PS und dem Potential der negativen Spannungsquelle NS liegenden Potential beaufschlagt werden.

Weiterhin ist der Modul-Gateanschluß G auch an eine Klemmeinrichtung K angeschlossen, die die Aufgabe hat, in einem Kurzschlußfall beispielsweise zwischen einem externen Kollektoranschluß C und einem externen Emitteranschluß E des Moduls M die Gatespannung UG, d. h. die Gatespannung UG1 des Chips Ch1, die Gatespannung UG2 des Chips Ch2, ... und die Gatespannung UGn des Chips Chn möglichst nicht ansteigen zu lassen. Diese externe Klemmeinrichtung K besteht aus einer Reihenschaltung einer Zener-Diode Z mit einem Kondensator C1 zwischen einem festen Potential P1 und einer Spannungsquelle E (N), wobei ein Verbindungspunkt Uk mit der Klemmspannung UK zwischen der Diode Z und dem Kondensator C1 über eine Klemmdiode KD an den Modul-Gateanschluß G angeschlossen ist.

Tritt an dem Modul M ein ausgangsseitiger Kurzschluß auf, so steigt die Spannung zwischen dem Kollektoranschluß C und dem Emitteranschluß E an. Diese Spannungsänderung bewirkt einen Stromfluß (Millerstrom) durch die sogenannten n Millerkapszitäten CGC1, CGC2, ..., CGCn, die in Fig. 4 mit Strichlinien schematisch angedeutet sind. Dieser Strom durch die Millerkapazitäten CGC1, CGC2, ..., CGCn muß durch die n Gatewiderstände RG1, RG2, ..., RGn fließen, bevor er durch die Klemmdiode KD in den großen Klemmkondensator C1 abgeleitet werden kann. Ausgehend von dem Potential UK an dem Verbindungspunkt Uk zwischen der Zener-Diode Z und dem großen Klemmkondensator C1, welches von diesem großen Klemmkondensator C1 unabhängig von der Höhe des Stromes durch die Millerkapazitäten CGC1, CGC2, ..., CGCn näherungsweise konstant gehalten wird, addiert sich darauf noch der Spannungsabfall an der Klemmdiode KD, der etwa 0,7 V betragen kann, und der Spannungsabfall an den internen Gatewiderständen RG1, RG2, ..., RGn, der linear mit dem durch die Millerkapazitäten bedingten Millerstrom ansteigt.

Es ist nun zu beachten, daß die tatsächliche Gatespannung an den einzelnen Chips Ch1, Ch2, ..., Chn des Moduls M von einem Anwender im Modul M nicht direkt gemessen werden kann. Im Kurzschlußfall steigt aber der Kurzschlußstrom des Leistungshalbleiterbauelementes, im vorliegenden Beispiel des jeweiligen IGBTs, mit der Gatespannung sehr stark an, wie dies aus Fig. 5 zu ersehen ist, in der der Logarithmus lg des Kollektorstromes I_{c} in Abhängigkeit von der Gate-Emitter-Spannung U_{GE} aufgetragen ist, wobei die Kollektor-Emitter-Spannung U_{CE} über 30 V liegt. Eine Gate-Emitter-Spannung U_{GE} von beispielsweise 15 V führt zu einem Kollektorstrom I_{C} mit der Größe I_{K}. Wird die Gate-Emitter-Spannung U_{GE} nur geringfügig erhöht, so tritt bereits für den Kollektorstrom I_{C} ein Wert auf, der das Zehnfache des Stromes I_{K} beträgt.

Es wurde nun erkannt, daß der Spannungsabfall an den internen Gatewiderständen RG1, RG2, ..., RGn nicht unbeträchtlich zu dem erhöhten Kurzschlußstrom und somit zu einer starken Belastung des Leistungshalbleiterbauelementes bzw. des Moduls bis zu dessen Zerstörung beiträgt.

Das minimale Niveau der Klemmspannung UK kann nicht weiter verringert werden, da das Leistungshalbleiterbauelement im normalen, eingeschalteten Zustand eine minimale Gatespannung von beispielsweise 15 V für ein gutes Durchlaßverhalten benötigt.

Schließlich ist aus der US-A-4 207 478 eine Multichip-Anordnung gemäß Oberbegriff des Anspruchs 1 bekannt, welche aus mehreren Bipolartransistoren besteht und, bei der diese Transistoren über Parallelschaltungen von Widerständen und Dioden an eine externe Treiberschaltung angeschlossen sind.

Es ist Aufgabe der vorliegenden Erfindung, eine Multichip-Anordnung zu schaffen, bei der eine Erhöhung des Kurzschlußstromes infolge interner Gatewiderstände vermieden wird.

Diese Aufgabe wird bei einer Multichip-Anordnung der eingangs genannten Art erfindungsgemäß dadurch gelöst, daß die Steueranschlüsse gemeinsam über die Parallelschaltungen der Widerstände und Dioden auch an eine zusätzliche Klemmeinrichtung angeschlossen sind. Bei einer solchen Beschaltung der Multichip-Anordnung kann in dieser auf interne Gatewiderstände verzichtet werden, so daß der Spannungsabfall über diesen minimiert ist bzw. vernachlässigt werden kann.

In einer vorteilhaften Weiterbildung der Erfindung ist vorgesehen, daß jedem Halbleiterchip ein Modul-Gateanschluß zugeordnet ist und daß die Widerstände und die Dioden außerhalb des Moduls angeordnet sind.

Eine andere vorteilhafte Weiterbildung der Erfindung zeichnet sich dadurch aus, daß das Modul einen Gateanschluß und einen Klemmanschluß hat und daß innerhalb des Moduls jeweils die Widerstände des Halbleiterchips und die Dioden des Halbleiterchips gemeinsam an den Gateanschluß bzw. an den Klemmanschluß angeschlossen sind. Nachfolgend wird die Erfindung anhand der Zeichnungen näher erläutert. Es zeigen:
- Fig. 1: ein Schaltbild einer ersten nicht beanspruchten Multichip-Anordnung,
- Fig. 2: ein Schaltbild einer zweiten nicht beanspruchten Multichip-Anordnung,
- Fig. 3: ein Schaltbild eines Ausführungsbeispiels der erfindungsgemäßen Multichip-Anordnung,
- Fig. 4: ein Schaltbild einer bestehenden Multichip-Anordnung und
- Fig. 5: den Verlauf des Kurzschlußstromes eines Leistungshalbleiterbauelementes in Abhängigkeit von der Gate-Emitter-Spannung.

Die Figuren 4 und 5 sind bereits eingangs erläutert worden.

In den Figuren werden einander entsprechende Bauteile jeweils mit den gleichen Bezugszeichen versehen.

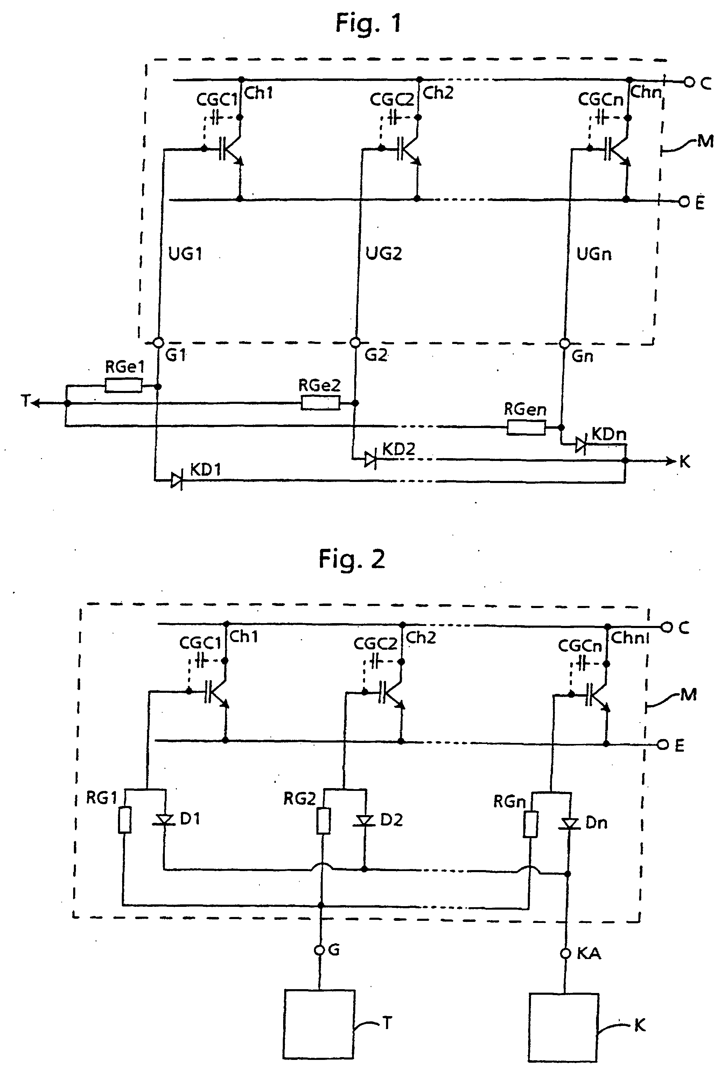

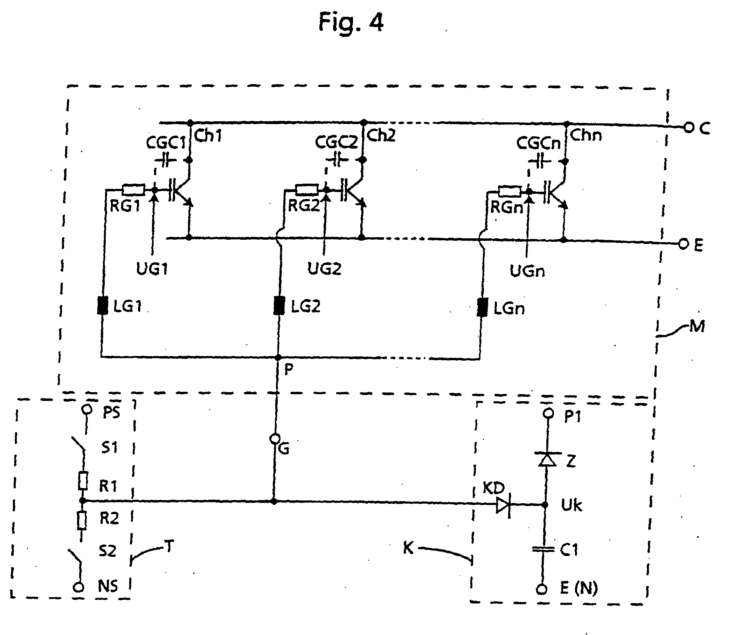

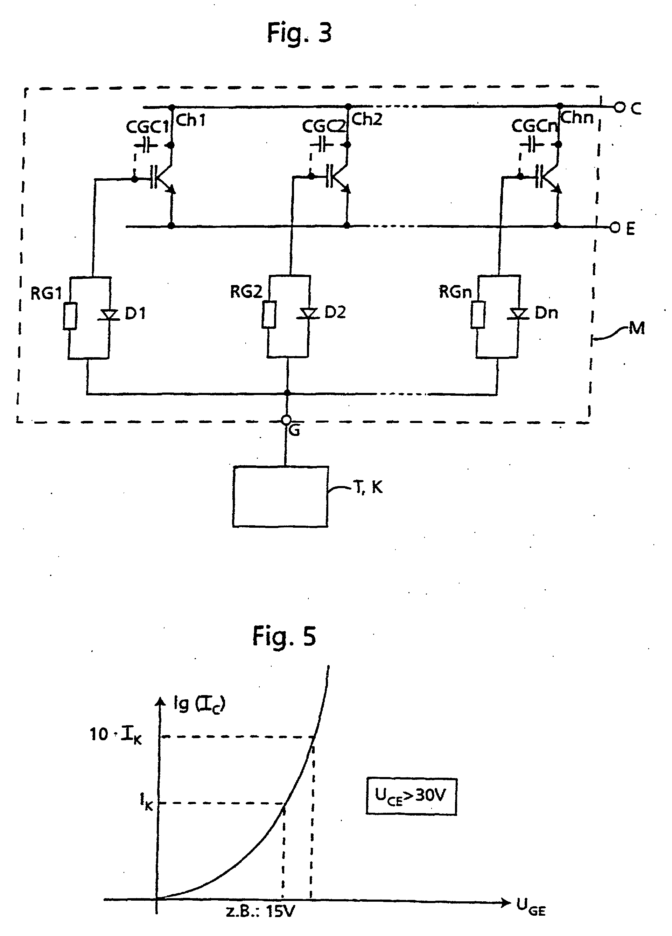

Bei dem Schaltungsbeispiel von Fig. 1 besitzt das Modul M n Gateanschlüsse G1, G2, ..., Gn, die jeweils direkt ohne interne Gatewiderstände RG1, RG2, ..., RGn (vgl. Fig. 4) an die Gates der IGBTs der Halbleiterchips Ch1, Ch2, ..., Chn des Moduls M angeschlossen sind. Diese n Gateanschlüsse G1, G2, ..., Gn sind über n Klemmdioden KD1, KD2, ..., KDn mit einer Klemmeinrichtung K verbunden, die der Klemmeinrichtung K von Fig. 4 ohne die dortige Klemmdiode KD entspricht. Das heißt, der Ausgang der Klemmdioden KD1, KD2, ..., KDn ist an den Punkt Uk der Klemmeinrichtung K angeschlossen. Außerdem sind die Gateanschlüsse G1, G2, ..., Gn des Moduls M über n externe Gatewiderstände RGe1, RGe2, ..., RGen an die Treiberschaltung T (vgl. Fig. 4) angeschlossen. Durch diese Gatewiderstände RGe1, RGe2, ..., RGen wird die Entkopplung der Gateanschlüsse G1, G2, ..., Gn gewährleistet.

Fig. 2 zeigt ein Schaltungsbeispiel, bei dem die n Gateanschlüsse G1, G2, ..., Gn des Beispiels von Fig. 1 bereits intern miteinander verbunden sind. Im Gegensatz zu dem herkömmlichen Modul von Fig. 4 liegen hier zusätzlich parallel zu den Gatewiderständen RG1, RG2, ..., RGn noch jeweils Dioden D1, D2, ..., Dn, deren Kathoden zusammengeschlossen und mit einem einzigen Klemmanschluß KA des Moduls M verbunden sind. An diesem Klemmanschluß KA ist die Klemmeinrichtung K angeschlossen, während an einem gemeinsamen Gateanschluß G des Moduls M die Treiberschaltung T liegt.

Bei dem Schaltungsbeispiel von Fig. 2 benötigt die Klemmeinrichtung K selbst keine Klemmdiode KD (vgl. Fig. 4) mehr, so daß die Spannung der Gates der einzelnen Halbleiterchips Ch1, Ch2, ..., Chn diejenige des Klemmkondensators C1 (vgl. Fig. 4) nur um etwa 0,7 V, unabhängig von der Höhe des Millerstromes, übersteigt.

Vorteilhaft an der Anordnung von Fig. 2 ist gegenüber der Anordnung von Fig. 1 die geringere Anzahl der notwendigen Anschlüsse: anstelle der n Gateanschlüsse G1, G2, ..., Gn des Ausführungsbeispiels von Fig. 1 werden lediglich der Gateanschluß G und der Klemmanschluß KA für das Modul M benötigt. Die Widerstände RG1, RG2, ..., RGn und/oder die Dioden D1, D2, ..., Dn können auf dem jeweiligen Halbleiterchip Ch1, Ch2, ..., Chn integriert oder diskret ausgeführt sein.

Fig. 3 zeigt ein Ausführungsbeispiel der erfindungsgemäßen Multichip-Anordnung, bei der im Vergleich zu der herkömmlichen Chip-Anordnung von Fig. 4 überhaupt kein zusätzlicher Modulanschluß für das Modul M benötigt wird. Hier sind die Dioden D1, D2, ..., Dn jeweils direkt zu ihrem zugehörigen Gatewiderstand RG1, RG2, ..., RGn parallel geschaltet, was den Klemmanschluß KA entbehrlich macht. Die Klemmeinrichtung K benötigt allerdings wieder eine Klemmdiode KD (vgl. Fig. 4), da der Gateanschluß G beim Ausschalten auf Emitterpotential liegt und den Klemmkondensator C1 sonst entladen würde. Bei der Dimensionierung der Treiberschaltung T ist zu berücksichtigen, daß der interne Gatewiderstand RG1, RG2, ..., RGn sich nur beim Einschalten des Moduls M zu dem externen Gatewiderstand in der Verbindung zwischen dem Gateanschluß G und der Treiberschaltung T addiert, während beim Ausschalten die Dioden D1, D2, ..., Dn mit nahezu konstantem Spannungsabfall wirksam sind. Eine Überladung der Gates der einzelnen Halbleiterchips Ch1, Ch2, ..., Chn gegenüber der Klemmspannung UK an den Verbindungspunkt Uk der Klemmeinrichtung K (vgl. Fig. 4) beträgt etwa das Zweifache des Durchlaßspannungsabfalles einer Diode D1, D2, ..., Dn, also etwa 1,4 V und ist nahezu unabhängig von der Höhe des Millerstromes.

Die Widerstände RG1, RG2, ..., RGn und/oder die Dioden D1, D2, ..., Dn können wie beim Schaltungsbeispiel von Fig. 2 auf dem jeweiligen Halbleiterchip Ch1, Ch2, ..., Chn integriert oder aber diskret ausgeführt sein. In jedem Fall befinden sich diese Widerstände und Dioden aber innerhalb des Moduls M.

An den Schaltungsbeispielen der Figuren 2 und 3 ist von besonderem Vorteil, daß die Gatewiderstände RG1, RG2, ..., RGn und die jeweiligen Klemmdioden D1, D2, ..., Dn auf den entsprechenden Chips Ch1, Ch2, ..., Chn integriert sind, wodurch die Anzahl der Bauelemente reduziert ist. Bei dem Ausführungsbeispiel von Fig. 3 ist außerdem kein zusätzlicher Bonddraht erforderlich, da nur ein Anschluß G vorliegt.

Zur Vereinfachung sind in dem Ausführungsbeispiel von Fig. 3 noch die Treiberschaltung T und die Klemmeinrichtung K in einem Block T, K zusammengefaßt dargestellt. Gegebenenfalls können diese Schaltungen T und K auch in eine Einheit integriert sein.

### Bezugszeichenliste

- Ch1, Ch2, ..., Chn: Halbleiterchips
- RG1, RG2, ..., RGn: Gatewiderstände
- UG1, UG2, ..., UGn: Gatespannungen
- LG1, LG2, ..., LGn: Gateanschlüsse der einzelnen Halbleiterchips
- P: Verbindungspunkt der einzelnen Gateanschlüsse
- CGC1, CGC2, ..., CGCn: Millerkapazitäten
- M: Modul
- C: Kollektoranschluß
- E (N): Spannungsquelle
- I_{C}: Kollektorstrom
- T: Treiberschaltung
- K: Klemmeinrichtung
- PS: positive Spannungsquelle
- NS: negative Spannungsquelle
- S1, S2: Schalter
- R1, R2: Widerstände
- Z: Zener-Diode
- KD: Klemmdiode
- C1: Klemmkondensator
- Uk: Verbindungspunkt zwischen Zener-Diode Z und Klemmkondensator C1
- UK: Klemmspannung
- RGe1, RGe2, ..., RGen: externer Gatewiderstand
- KD1, KD2, ..., KDn: externe Klemmdioden
- G1, G2, ..., Gn: Gateanschlüsse der Halbleiterchips
- D1, D2, ..., Dn: Dioden
- P1: Potential
- G: Modul-Gateanschluß
- lg: Logarithmus
- U_{GE}: Gate-Emitter-Spannung
- U_{CE}: Kollektor-Emitter-Spannung
- I_{K}: Kollektorstrom
- KA: Klemmanschluß

## Patentansprüche

1. Multichip-Anordnung aus einer Vielzahl von zueinander in einem Modul (M) parallel geschalteten Halbleiterchips (Ch1, Ch2, ..., Chn), deren Steueranschlüsse gemeinsam jeweils über einen Widerstand (RG1, RG2 ..., RGn) und eine Diode (D1, D2, ..., Dn) an eine externe Treiberschaltung (T) angeschlossen sind, wobei:
das Modul (M) nur einen Gate- und Klemmanschluss (G) hat und innerhalb jedes Halbleiterchips (Ch1, Ch2, ..., Chn) die jeweiligen Widerstände (RG1, RG2, ..., RGn) und Dioden (D1, D2, ..., Dn) parallel zueinander geschaltet und die jeweiligen Parallelschaltungen der Widerstände (RG1, RG2, ..., RGn) und Dioden (D1, D2, ..., Dn) der einzelnen Halbleiterchips (Ch1, Ch2, ..., Chn) gemeinsam an den Gate- und Klemmanschluss (G) angeschlossen sind,
**dadurch gekennzeichnet, dass**
die Steueranschlüsse gemeinsam über die Parallelschaltungen der Widerstände (RG1, RG2, ... RGn) und Dioden (D1, D2, ..., Dn) auch an eine zusätzliche Klemmeinrichtung (K) angeschlossen sind.

2. Multichip-Anordnung nach Anspruch 1,
**dadurch gekennzeichnet, dass**
der Halbleiterchip (Ch1, Ch2, ..., Chn) einen IGBT, MOS-Leistungstransistor oder Thyristor enthält.

3. Multichip-Anordnung nach Anspruch 1 oder 2,
**dadurch gekennzeichnet, dass**
in den Halbleiterchips (Ch1, Ch2, ..., Chn) Millerkapazitäten (CGC1, CGC2, ..., CGCn) vorliegen.

4. Multichip-Anordnung nach einem der Ansprüche 1 bis 3,
**dadurch gekennzeichnet, dass**
die Widerstände (RG1, RG2, ..., RGn) und/oder die Dioden (D1, D2, ..., Dn) auf dem jeweiligen Halbleiterchip (Ch1, Ch2, ..., Chn) integriert ausgeführt sind.

## Claims

1. Multichip arrangement comprising a multiplicity of semiconductor chips (Ch1, Ch2, ..., Chn) which are connected in parallel with one another in a module (M) and whose control terminals are jointly connected, via a resistor (RG1, RG2, ..., RGn) and a diode (D1, D2, ..., Dn) in each case, to an external driver circuit (T), the module (M) having only a gate and clamping terminal (G), and within each semiconductor chip (Ch1, Ch2, ..., Chn) the respective resistors (RG1, RG2, ..., RGn) and diodes (D1, D2, ..., Dn) being connected in parallel with one another, and the respective parallel circuits of the resistors (RG1, RG2, ..., RGn) and diodes (D1, D2, ..., Dn) of the individual semiconductor chips (Ch1, Ch2, ..., Chn) being jointly connected to the gate and clamping terminal (G), **characterized in that** the control terminals are also jointly connected, via the parallel circuits of the resistors (RG1, RG2, ..., RGn) and diodes (D1, D2, ..., Dn) also to an additional clamping device (K).

2. Multichip arrangement according to Claim 1, **characterized in that** the semiconductor chip (Ch1, Ch2, ..., Chn) contains an IGBT, an MOS power transistor or a thyristor.

3. Multichip arrangement according to Claim 1 or 2, **characterized in that** there are Miller capacitors (CGC1, CGC2, ..., CGCn) present in the semiconductor chips (Ch1, Ch2, ..., Chn).

4. Multichip arrangement according to one of Claims 1 to 3, **characterized in that** the resistors (RG1, RG2, ..., RGn) and/or the diodes (D1, D2, ..., Dn) are integrated on the respective semiconductor chip (Ch1, Ch2, ..., Chn).

## Revendications

1. Dispositif multipuce constitué d'une multiplicité de puces à semi-conducteur (Ch1, Ch2, ..., Chn) qui sont branchées en parallèles les unes avec les autres dans un module (M) et dont les bornes de commande sont raccordées en commun respectivement par l'intermédiaire d'une résistance (RG1, RG2, ..., RGn) et d'une diode (D1, D2, ..., Dn) à un circuit d'attaque exteme (T),
le module (M) ayant seulement une borne de grille et de verrouillage (G), à l'intérieur de chaque puce à semi-conducteur (Ch1, Ch2, ..., Chn), les résistances respectives (RG1, RG2, .., RGn) et les diodes respectives (D1, D2, ..., On) étant branchées en parallèles les unes avec les autres, et les montages parallèles des résistances (RG1, RG2, .., RGn) et des diodes (D1, D2, ..., Dn) des différentes puces à semi-conducteur (Ch1, Ch2, ..., Chn) étant raccordés en commun à la home de grille et de verrouillage (G),
**caractérisé par le fait que** les bornes de commande sont raccordées en commun par l'intermédiaire des montages parallèles des résistances (RG1, RG2, .., RGn) et des diodes (D1, D2, ..., Dn) à un dispositif de verrouillage (K) supplémentaire.

2. Dispositif multipuce selon la revendication 1, **caractérisé par le fait que** la puce à semi-conducteur (Ch1, Ch2, ..., Chn) contient un IGBT, un transistor de puissance MOS ou un thyristor.

3. Dispositif multipuce selon la revendication 1 ou 2, **caractérisé par le fait qu'**il y a dans la puce à semi-conducteur (Ch1, Ch2, ..., Chn) des capacités de Miller (CGC1, CGC2, ..., CGCn).

4. Dispositif multipuce selon l'une des revendications 1 à 3, **caractérisé par le fait que** les résistances (RG1, RG2, .., RGn) et/ou les diodes (D1, D2, ..., Dn) sont réalisées intégrées sur la puce à semi-conducteur (Ch1, Ch2, ..., Chn) respective.
